Europäisches Patentamt

European Patent Office

Office européen des brevets

(11) Publication number: **0 212 931**
A1

## (12) EUROPEAN PATENT APPLICATION

(21) Application number: 86306219.6

(22) Date of filing: 12.08.86

(51) Int. Cl.⁴: **H 01 T 23/00**, G 01 R 15/07

(30) Priority: 16.08.85 GB 8520543
27.02.86 GB 8604859

(43) Date of publication of application: 04.03.87
Bulletin 87/10

(84) Designated Contracting States: **AT BE CH DE FR IT LI LU NL SE**

(71) Applicant: **Sidha Technology Limited, Peel House Peel Road, West Pimbo Skelmersdale Lancashire WN8 9PT (GB)**

(72) Inventor: **Gay, Geoffrey Norman Walter, 73 Ennerdale Tanhouse, Skelmersdale Lancashire, WN8 6AQ (GB)**

(74) Representative: **Lyons, Andrew John et al, ROYSTONS 531 Tower Building Water Street, Liverpool L3 1BA (GB)**

(54) **Improvements relating to air ionizers.**

(57) Air ionizer has high voltage ion flow rate detection means (14), low voltage operated means and sensing means (30) non-electrically coupled to the detection means (14) to provide ion flow related indication (34) or control; and/or ion emission probe(s) (112) in a Faraday cage (110) about forced air passage in exit grille (114) and affording air-flow-permitting but electric-field-escape obstructing; and/or multi-level control (64, 84) of probe(s) energisation and/or air flow speed shown with corresponding indicator means (72, 92).

- 1 -

Title: Improvements relating to air ionizers

DESCRIPTION

This invention arises in relation to air ionizers, and to problems attaching to indicating ion flow also convenient control of ionizers.

We are established manufacturers of air ionizers, and have long been aware of proposals for indicating ion flow by the rate at which a **neon** discharge light device switches on and off, see for example British patent specifications nos. 1305382 and 1589331 where such a neon device is connected in parallel with a capacitor as a relaxation oscillator supplied electrically from a conductor electrically separate from but associated with an ionizing probe in the electric field established by high voltage energisation of such probe. It is, of course, not necessary to use such conductors, whether as rings or plates, in order to get satisfactory operation of air ionizer probes, typically at supply voltages of 4.5KV to 7KV, but could be substantially higher, say 15KV. Moreover, it is possible to connect a neon/capacitor relaxation oscillator directly in the high voltage feed to the probe in order to get the aforementioned rate of neon flashing proportional to ion flow. However, neon flashing is not always particularly easy for the user to see clearly, for example in high ambient light conditions, and, for direct connection, there is danger of leakage to ground and shock when placed in a normal viewing position, e.g. on a control panel. Thus, we have, hitherto, not ourselves used such flashing neon indicators, despite recognising the usefulness of their intended function.

We have, in fact, considered alternatives to such neon flashing, in particular using relaxation oscillators employing unijunction transistors or break-over diodes and, in series therewith, non-discharge type light devices such as light emitting diodes (LEDs), even perhaps electroluminescent panel devices. Also, however, we have considered non-flashing alternatives relying on intensity or brightness of light, for example simply using gas discharge or electroluminescent devices directly in the probe feed line, i.e. without a parallel capacitor to give relaxation oscillator operation. Whilst all of these alternatives apperar capable of operation in direct connections to air ionizer probes, or relative to electrically separate conductors associated with the probes as in the above-noted prior patent specifications, they still suffer the same disadvantages as prior neon flashing in being limited as to their type, mode and brightness of indication and isolation/safety

- 3 -

of operation by reference to their context of operation, which, whilst a particularly simple and elegant solution to obtaining indication of operation of a high voltage activity at a high potential is inherently at odds with voltage requirements of modern solid-state semiconductor devices.

In seeking to provide an alternative to such indicators, this invention proposes that actual indicator means, i.e. as viewed or intended to be viewed by the user, be provided electrically separate from detection means (that can take the form of the aforementioned neon etc, flashing and/or alternatives, or other suitable forms), so that the actual indicator means can be of low voltage type and/or of other type but with isolation from the high voltage feed to the probe(s), in any event, with characteristics decided solely in relation to the needs of the user, say as conventional LEDs, lamps, bargraphs, meters, digital displays, etc, such indicator means being in circuitry including sensing means responsive to the state of the detection means, for example using electro-optic or opto-electric means. It is further preferred for such indicator means to be operable only on demand.

According to one aspect this invention

0212931

- 4 -

proposes an air ionizer for which a probe has detection means responsive according to ion flow, and normally operable either directly at high voltage levels and/or high impedance levels associated with the probe's electrical supply or a voltage level related thereto and still higher than normal semiconductor operating voltages and/or impedances, indicator means in circuitry operative at lesser voltage levels and/or impedances, normally the relative low voltage/impedance levels appropriate to low-cost semiconductor devices, and sensing means by which the latter circuitry is provided with signals related to the state or condition of the detection means.

Using detection means comprising a neon or other discharge device/capacitor relaxation oscillator, which has the notable advantage of virtually zero leakage between firings of the neon discharge device, conveniently with such oscillator directly in the probe feed line, the sensing means can be a photoelectric device, such as a phototransistor, at the input side of a suitable amplifier, say of two st ge emitter follower type, having the indication means in its output side and all conveniently connected across a low voltage supply whether entirely separate from the probe supply or derived therefrom. However, such sensing and detection means are considered applicable to the alternatives mentioned above.

Development of such indicator system using sensing means to introduce a level of indication by way of producing a low voltage sense signal leads us to another aspect of this invention in terms of further or alternatively providing that such output be used for control purposes, i.e. rather than or additionally to the above safe and reliable indication system. That can be achieved in a loop so as to provide improved control of energisation of the probe(s), preferably in relation to achieving more consistent ion flow. A suitable control loop comprises sensing means operative to produce a low voltage level signal from detection means for ion flow, say as above connected directly into the high voltage feed to the probe(s) and usually of analogue rather than pulsing type (though integration could be used for or from the latter), and a comparator responsive to such sense signal and a reference signal, preferably variable within a desired range, for producing an output to which low voltage-operated control circuitry is operative, such as triac circuitry controlling input to the high voltage source. This proposal constitutes a second aspect of this invention.

Our development work for a new model of ionizer has led, as with the above-mentioned control aspect, to other features that are both advantageous in conjunction with improved provision for visual indication of ion flow and with merit in themselves.

One such provision against the tendency for deposition of dirt on adjacent surfaces due to external electrical field effects of ionizer operation, which provision subsists in a Faraday cage about the ionizer emission electrode(s), preferably with the action across the actual ion emission exit as attainable by a conducting grille, such as a metal, coated-metal or metal-coated grille, affording little resistance to forced air flow carrying out emitted ions but effective reduction if not virtual elimination of electric field escape/extension beyond such grilled exit. Such provision has a relation to ion flow indication as false readings are possible when air flow forcing ceases but are substantially avoided if the ionising voltage supply is cut off when forced flow ceases.

Another feature concerns improved flexibility of operation of air ionizers, is provision of two or more, conveniently four, selectable levels of probe energisation are provided, preferably with two or more, conveniently four, selectable rates of air flow through the ionizer, further preferably with indication means for the or each selected level or rate. Simple resistive branches can be used for probe voltage level setting and fan speed control.

Then, the same air ionizer can be used for purposes
as diverse as personally, say at the bedside, and for
multiple occupation offices and with low ionization/low
air flow through all variations of either to high
ionization/high air flow.

A further such feature arises particularly from
provision for use of a high power fan, for example
a high velocity tangential fan, when its speed control
is found advantageously to be via selectable resistances
in live line feed branches.

Specific implementation of this invention will now
be described, by way of example, with reference to the
accompanying drawings, in which:

Figure 1 is an electric circuit diagram showing
ion flow indication;

Figures 2A-2D show alternative ion flow detection;

Figure 3 is an electric circuit diagram showing
variable energisation/air flow and related indication;

Figure 4 shows an ion-flow control loop; and

Figure 5 is a further ionizer diagram.

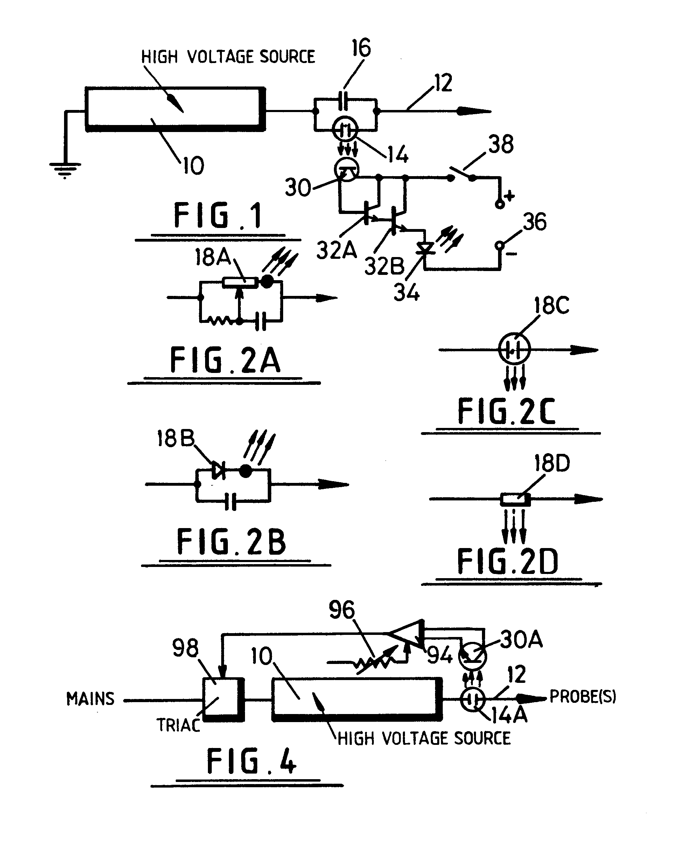

In the drawings, referring first to Figure 1, an air ionizer is shown with a high voltage source 10 supplying a probe feed line 12 via a parallel connection of a neon discharge device 14 and a capacitor 16 operating as a relaxation oscillator producing neon flashing at a rate dependent on ion flow from the probe or probes.

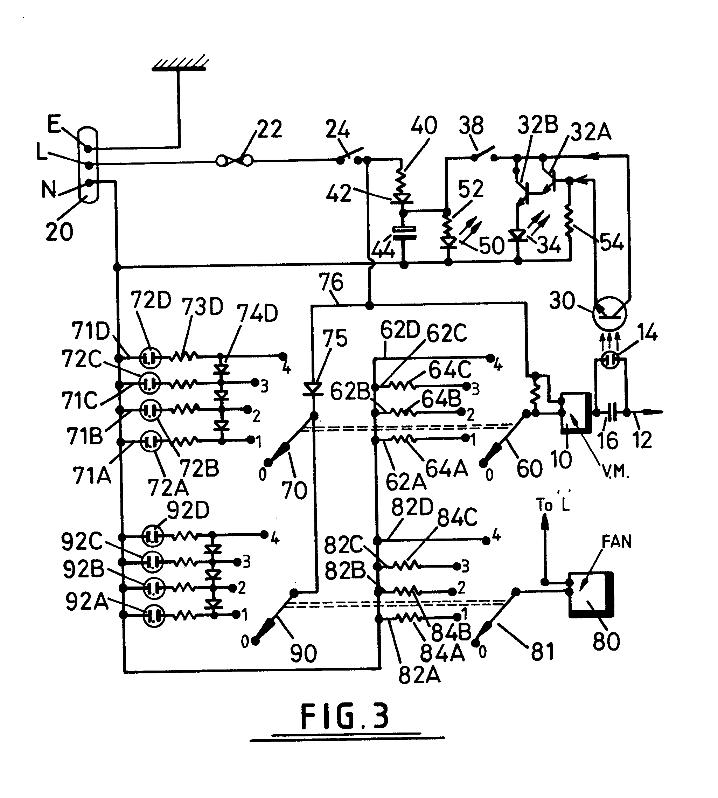

In practice, for an alternating mains voltage supply above 200 volts, the high voltage source 10 can be a voltage multiplier stack capable of producing a d.c. output voltage of between about 4.5 K-volts and 7 K-volts, when the stack may be supplied from a mains output 20 via a fuse 22 and switch 24 in the live line, see Figure 3.

Electrically isolated from the neon device 14, but in suitable proximity for desired optical coupling, is an optical sensor shown as a phototransistor 30 at the input of a two-stage emitter follower transistor amplifier 32A, 32B driving an LED 34, the circuitry 30 to 34 being shown in Figure 1 supplied by a low voltage source 36, which can conveniently be obtained by a voltage dropping over a resistor 40 from a mains live line L through a diode 42 and from between that diode 42 and a blocking/smoothing capacitor 44 connected to the mains neutral line N, see Figure 3. An associated switch 38 assures that ion flow indication is selectively available, say by pressing a push-button.

Figure 3 further shows an indicator 50 for general on/off purposes, specifically an LED fed via a resistor 52 from low voltage derived at the junction of diode 42 and capacitor 44. It is preferred that the indicators 34 and 50 be of different colours, say red for mains on/off (50) and green for ion flow (34). A stablising resistor 54 is also shown in Figure 3 from the amplifier input to the neutral supply line.

It will be appreciated that the phototransistor 30 could be replaced by any other suitable opto-electric device, such as a photodiode, that the amplifier 32 could be of other type, such as using an operational amplifier, and that the LED 34 could be any other suitable indicator means, such as an incandescent lamp, etc. Moreover, the essentially pulsed input to the circuitry sensing device 30 and amplifier 32 could be converted to analogue form, for example using an integrator, and used to drive an analogue indication device, such as a moving coil meter, bargraph, liquid crystal display etc.

It will also be appreciated that discharge devices other than neon type can be used.    Also, the operating
voltage level could be higher than 7KV.

Pulsing alternatives to the neon or other discharge
device/capacitor relaxation oscillator are shown in Figures
2A and 2B, also as relaxation oscillators using capacitors
(C), but with a unijunction transistor 18A and resistor
(Figure 2A), or a break-over diode 18B (Figure 2B) such as
a tunnel diode or diac, in series with a light emitter
device, such as an LED.    Each can replace the neon-capacitor
relaxation oscillator 14/16 of Figure 1, though greater care
may be required to assure oscillation in view of leakage
currents through unijunction transistors and breakover
diodes.

Non-pulsing alternatives to the neon/capacitor
relaxation oscillator 14/16 are shown in Figures 2C and
2D both for analogue detection of ion flow, and using a
neon discharge device 18C or electroluminescent device
18D in the probe feed line 12 arranged so as to have a
brightness corresponding to ion flow.    Unless translation
to pulse or digital format is used, such inherently
analogue detection means and signal will be used to drive
an analogue display.

Referring further to Figure 3, it will be noted that the high voltage source 10 is shown with an
effectively variable supply voltage, actually in a
step-wise manner. Thus a five position switch 60 is
shown for selecting between OFF and four effective supply
voltage levels via branches 62A-62D from the mains neutral
line N, branches 62A-62C having resistors 64A-64C
therein and branch 62D having no resistor. With
resistors 64A-64C of suitable progressively smaller values,
the switch 60 can go from OFF through progressively
larger effective voltage differences for the voltage
multiplier 70, say for the latters output to range from
4.5KV to 7KV (or between other operating levels
as mentioned above) via two desired intermediate levels.
Ganged switching is indicated at 20 for branches 71A-71D
from the neutral line N for voltage levels indicator devices
72A-72D. The latter are shown as gas discharge devices
with related resistors 73 and diodes 74 for their desired
action from the mains live line via a diode 75 in branch 76.

Also, Figure 3 shows a fan 80 for inducing air flow
through the air ionizer with switch 81 also operative
relative to neutral line branches 82A-82D and resistors
84A-84C in essentially like manner as the voltage level
switch 60, but here to control fan speed and thus air flow rate in a variable, actually step-wise and four-level, manner. Again, similar ganged switching 90 and rate indicator devices 92 are shown, i.e. as for the indicators 72 of switching 70.

It will readily be appreciated that low voltage indicators could be used for 72 and 92, say with appropriate supply from a low voltage source, for example additonal to the afore-described ion-flow sensing, of Figure 3, but still from the mains supply.

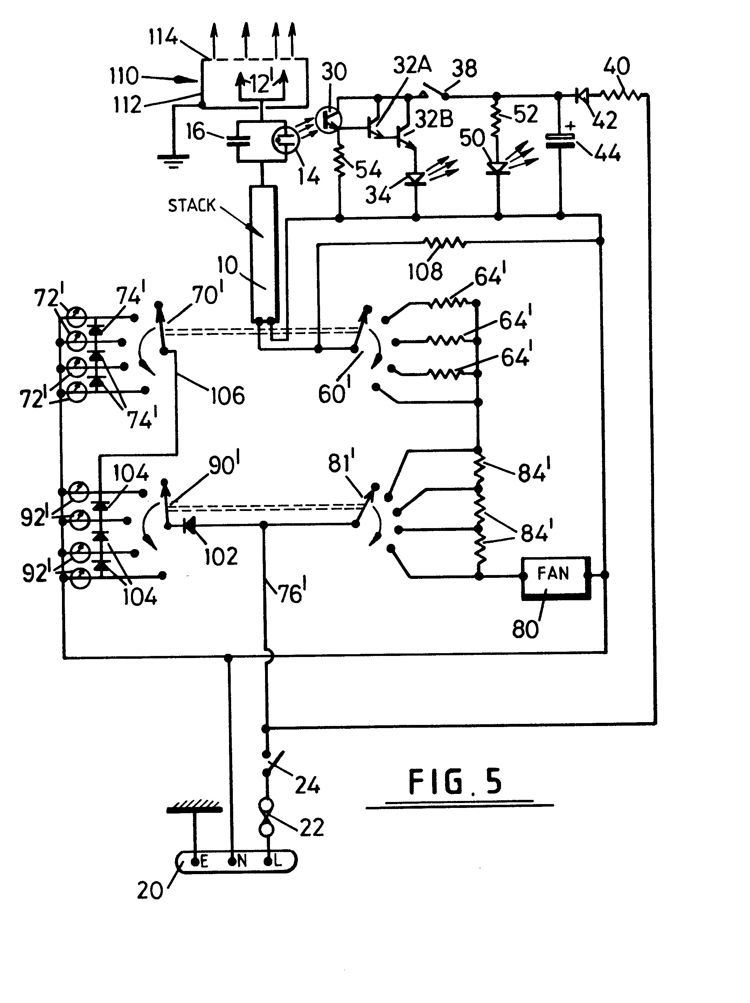

Turning to Figure 4, a suitable detection device in the probe feedline 12 is shown as a neon discharge device 14A further shown an optical coupling with a suitable sensing device, shown as a phototransistor 30A, to produce a low-voltage proportionate signal as input to an operational amplifier 94 configured as a comparator also receiving a range variable reference signal level, see 96, and affording an output controlling circuitry 98, which can be of triac type, for controlling mains input to the high voltage source 10 so as to control actual voltage of probe energisation in order to maintain a demanded level of ion flow corresponding to the setting of the comparator.

In the embodiment of Figure 5, fan speed resistors 84' are shown in series, which we find advantageous at least in relation to using a higher power fan, for

## 0212931

- 13 -

example a high velocity tangential fan unit. It is further convenient to have such resistors made available via the fan speed control switch 81' effectively via live line branches from feed 76' also going via a diode 102 to the ganged switch 90' and rate indicator devices 92'.

Another feature found advantageous in relation to the Figure 5 embodiment is to use ion emission needles 12' in a Faraday cage 110, conveniently of earthed metal construction and serving to eliminate external electrical field effects and thus deposition of dirt on adjacent surfaces. A suitable Faraday cage comprises a conducting outer tube 112, such as a sheet metal, coated-metal or metal-coated tube, which can be of rectangular section, with the fan 80 blowing into it from behind and its front-exit having a conductive grille 114, such as a metal, metal-coated or coated-metal grille, as part of the Faraday cage system to at least reduce front escape of the electric field, i.e. limit output to ions when the fan is operative. The front grille should obviously not significantly resist fan-driven air-flow, but should restrict field escape. A metal lath type grille is suitable, say using thin laths having a width or depth into the Faraday cage sufficient at their spacing to restrict field escape. In one specific embodiment an

0212931

-14 -

outer rectangular tube, say of sheet aluminium, measures about 60 mm x 200 mm, serves a two-electrode system spaced at 90 mm, and has a seven-lath grille each lath extending about 6 mm into the cage. This grilled Faraday cage feature is believed to have merit in itself.

As ion current flow can occur from the emission electrodes or needles to inside surfaces of the Faraday cage even when the fan is switched off, false indication of ion output conditions is avoided by assuring that the voltage multiplier stack supply is off except when the fan is on, and thus that the ion output and monitor indicators cannot have positive signals when ions are not being driven out through the grille. That is achieved by taking the stack live side via the fan speed switch 81' and over selectable energisation (stack voltage) control resistor arms 64' of switch 60', such resistors generally having much higher values than those 84' controlling fan speed and forming a voltage divider with resistor 108.

In order for ion output indicator lamps to be correspondingly operative, they are shown powered from switch 90' via diodes 104 and line 106 to the switch 70'.

CLAIMS

1. Air ionizer comprising electrically operated detection means responsive according to ion flow, electronic means operative only at lower voltage than the detection means but required so operative according to ion flow, and sensing means responsive to said detection means to provide signals to said operative means representative of ion flow.

2. Air ionizer according to claim 1, wherein said operative means serves for ionizer control.

3. Air ionizer according to claim 1 or claim 2, wherein said operative means serves or also serves as ion flow indicator means.

4. Air ionizer according to claim 3, wherein said indicator means produces a visual indication at normal semiconductor operating voltages.

5. Air ionizer according to any preceding claim, wherein the detection means is serially between high voltage probe drive source and ion emitting probe itself.

6. Air ionizer according to claim 5, wherein the detection means comprises an electric discharge device.

7. Air ionizer according to claim 6, wherein the detection means comprises a neon lamp.

8. Air ionizer according to any preceding claim wherein the detection means produces light and the sensing means comprises a photoelectric device in circuitry for energising said operative means.

9. Air ionizer according to any preceding claim, comprising a Faraday shield extending about ion emission probe(s) past which and within the shield a forced air flow can be passed in operation, the shield having an air flow exit grille permitting said air flow but obstructive of electrical field extension therethrough.

10. Air ionizer according to claim 9, wherein said shield is tubular and said grille has spaced slats.

11. Air ionizer according to any preceding claim, comprising means affording two or more selectable levels of ion emission probe(s) energisation.

12. Air ionizer according to any preceding claim, comprising means affording two or more selectable rates of forced air flow past ion emission probe(s).

13. Air ionizer according to claim 11 or claim 12, wherein said means affording comprises selectable electrical resistance branches in probe voltage level setting circuitry or fan speed control circuitry.

14. Air ionizer according to claim 13 with claim 12, comprising a high speed fan or forced air flow and resistance branches of said means affording rate control are in electric live line feed branches for the fan.

15.   Air ionizer according to claim 11, 12, 13 or 14, comprising selection-representative indicator means associated with the or each said means affording.

1 — 3

0212931

HIGH VOLTAGE SOURCE

16

12

14

10

FIG.1

30

38

32A

32B

34

36

18A

FIG.2A

18C

FIG.2C

18B

FIG.2B

18D

FIG.2D

96

98

10

94

30A

12

MAINS

TRIAC

HIGH VOLTAGE SOURCE

14A

PROBE(S)

FIG.4

FIG.3

0212931

FIG. 5

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | FR-A-2 388 279 (O.N.E.R.A.) * Page 1, lines 3-8,30-34; page 3, line 18 - page 4, line 2; figure 2 * | 1,3-8 | H 01 T 23/00 G 01 R 15/07 |
| A | | 9,10 | |
| A | FR-A-2 339 975 (BURLINGTON IND.) * Page 7, lines 6-29; figure 4 * | 2,11 | |
| A | FR-A-2 380 504 (LAWS) * Page 5, line 29 - page 6, line 4; figure 4 * | 9 | |
| A | US-A-3 936 698 (MEYER) * Column 4, lines 11-21; figure 1 * | 12-14 | TECHNICAL FIELDS SEARCHED (Int. Cl.4) |
| A | FR-A-2 248 058 (LUQUEL) | | H 01 T A 61 N G 01 R |

The present search report has been drawn up for all claims

| Place of search | Date of completion of the search | Examiner |
|---|---|---|
| THE HAGUE | 13-11-1986 | BIJN E.A. |